# EUROPÄISCHE PATENTSCHRIFT

(11) **EP 2 315 513 B1**
(45) Veröffentlichungstag und Bekanntmachung des Hinweises auf die Patenterteilung: **15.04.2020**
(21) Anmeldenummer: 10186394.2
(22) Anmeldetag: 04.10.2010
(51) Int. Cl.: H05K 7/14

(54) **Toleranzfreie Leiterplattenklemmung**
Tolerance-free circuit board clamp
Serrage de plaques conductrices sans tolérance

(30) Priorität: 22.10.2009 DE 102009045915
(43) Veröffentlichungstag der Anmeldung: 27.04.2011
(73) Patentinhaber: Robert Bosch GmbH, 70442 Stuttgart (DE)
(72) Erfinder: Bossert, Sonja, 71735, Eberdingen (DE); Geissler, Alexander, 07616, Buergel (DE)

(56) Entgegenhaltungen:
- WO-A1-01/87029
- DE-A1-102004 027 859
- DE-A1-102004 052 202
- FR-A1- 2 679 408
- US-A- 5 144 533
- US-A1- 2006 077 642

## Beschreibung

### Stand der Technik

Die vorliegende Erfindung betrifft eine Leiterplattenhaltevorrichtung mit einem ersten und zweiten Klemmelement zum Einklemmen einer Leiterplatte sowie eine Leiterplattenanordnung mit einer erfindungsgemäßen Leiterplattenhaltevorrichtung.

Zur Fixierung von Leiterplatten existieren verschiedenste technische Lösungen. Die Leiterplatte kann direkt in das jeweilige Gehäuse geschraubt werden. Einkleben und Einklippsen sind auch gängige Montage-Methoden. Leiterplatten werden auch geklemmt. Dies geschieht meist, in dem Gehäuseteil direkt auf die Leiterplatte drücken. Schrauben und Klippsen setzt hohe Toleranzanforderungen bei Leiterplatte und Gehäuse vorraus. Wenn die Leiterplatte direkt geklemmt wird, sind die mechanischen Belastungen für die Leiterplatte, beispielsweise aufgrund von Wärmeausdehnung, enorm. Zusätzlich müssen für eine sichere Klemmung hohe Toleranzanforderungen eingehalten werden.

Aus der DE 100 22 968 A1 ist es bekannt, Klippse zum Einklippsen einer Leiterplatte in ein Gehäuse auch zum Kontaktieren der Leiterbahnen der Leiterplatte mit einem Anschlussstecker zu verwenden. Aus der DE 43 39 786 A1 ist es bekannt, Kunststoffnoppen zwischen einen Kühlkörper und ein zu kühlendes Bauteil zu setzen, so dass sich beim Aufdrücken des Kühlkörpers auf das Bauteil der wirksame Querschnitt zum Ableiten von Wärme erhöht.

Die Offenlegungsschrift US 2006/0077642 A1 zeigt ein Gehäuse in dem eine Leiterplatte durch mehrere Schrauben gehalten ist. Ausschließlich im Bereich der Schrauben sind elastische Elemente vorgesehen, die eine Verformung der Leiterplatte beim Anziehen der Schrauben verhindern sollen.

Die Offenlegungsschrift WO 01/87029 A1 zeigt eine Leiterplatte, die mittels Einpresspins verrastend in einem Gehäuse befestigt ist.

Die Offenlegungsschrift US 5144533 A1 zeigt eine Vorrichtung zur Befestigung einer Leiterplatte in einem Gehäuse, wobei Befestigungselemente mit vorgesehen sind, die die Leiterplatte von oben und unten klemmend festhalten. Dabei weist das obere Klemmelement einen elastischen Fortsatz auf, der zunächst in eine Öffnung der Leiterplatte eingreift und beim Schieben der Leiterplatte in die Endposition verformt wird, auf der Oberfläche der Leiterplatte aufliegt und die Leiterplatte damit auf die Auflagefläche des unteren Befestigungselements drückt.

Die Offenlegungsschrift FR 2679408 zeigt ein Gehäuse, in dem eine Leiterplatte durch Schrauben gehalten ist. Es sind Auflageflächen für die Ober- und Unterseite der Leiterplatte vorgesehen.
Aus der Offenlegungsschrift DE 102004027859 A1 ist eine Ausführung einer Leiterplatten bekannt, auf der schräg abstehende Klemmelemente fest angeordnet sind und mittels denen die Leiterplatte in einem Gehäuse klemmend gehalten werden kann.

### Offenbarung der Erfindung

Die erfindungsgemäße Leiterplattenhaltevorrichtung weist demgegenüber den Vorteil auf, dass trotz hoher Maßtoleranzen einer Leiterplatte eine sichere, feste und dauerhafte Fixierung der Leiterplatte in einem Gehäuse möglich ist. Hohe Toleranzanforderungen werden vermieden, in dem ein Toleranzausgleich stattfindet. Dieser Toleranzausgleich ist über einen großen Temperaturbereich gewährleistet, indem Ausdehnung und Zusammenziehen durch thermomechanische Ausdehnung ausgeglichen wird. Somit werden Verbiegen und Dehnung der Leiterplatte vermieden, was die Lebensdauer des Gesamtsystems steigert. Dies wird erfindungsgemäß durch Einfügen einer Elastizität beim Einklemmen einer Leiterplatte, oder einer anderen Einrichtung in einem Steuergerät, zwischen einem ersten und zweiten Klemmelement erreicht. Durch diese Elastizität kann Spiel in der Klemmung, sowie Schwingungen und Toleranzabweichungen aufgefangen werden. Die Toleranzanforderungen zwischen der Leiterplatte oder der anderen Einrichtung und dem Gehäuse können erheblich gesenkt werden, da sich die Klemmelemente an die Einbaubedingungen anpassen können. Auf diese Weise ist eine erfindungsgemäße Leiterplattenhaltevorrichtung geschaffen, die zum Klemmen und Fixieren einer Leiterplatte in allen elektrischen Geräte auf Leiterplattentechnologie verwendet werden kann. Die Klemmelemente umfassen elastische Abschnitte, fungieren aufgrund ihrer Elastizität als Puffer und nehmen einen automatischen Toleranzausgleich vor, wenn sich die Leiterplatte beispielsweise aufgrund von Wärme senkrecht zu ihrer Oberfläche hin ausdehnt. Daher gibt die Erfindung eine Leiterplattenhaltevorrichtung mit einem ersten und zweiten Klemmelement zum Einklemmen der Leiterplatte zwischen ihrer Oberseite und Unterseite an. Das erste Klemmelement umfasst erfindungsgemäß einen elastischen Abschnitt, der zur elastischen Aufnahme von mechanischen Kräften, insbesondere senkrecht zur Oberfläche der Leiterplatte, vorgesehen ist. Durch die Elastizität des ersten Klemmelementes können thermomechanische Ausdehnungen und Verformungen zwischen der Leiterplattenhaltevorrichtung und einer Leiterplatte ausgeglichen werden. Es gelangen weniger bis keine mechanischen Spannungen und Verbiegungen auf die Leiterplatte. Es handelt sich um eine nicht klebende Fixierung der Leiterplatte im Gehäuse, d.h. die Fixierung ist im Nachhinein lösbar und es entfallen chemische Inhaltsstoffe eines Klebers die eventuell die Leiterplatte und deren Bauteile beschädigen könnten. Durch die Elastizität des Klemmelements können ferner mechanische Vibrationen und Schwingungen gedämpft werden. Dies erhöht wiederum die Lebensdauer und die Zuverlässigkeit des Gesamtsystems.

Ferner umfasst auch das zweite Klemmelement einen elastischen Abschnitt, der zur elastischen Aufnahme von mechanischen Kräften senkrecht zur Oberseite der Leiterplatte vorgesehen ist. Dies hat Vorteile bei der Stoffauswahl. Die einzelnen Klemmelemente selbst können starrer und damit stabiler ausgelegt und die erfindungsgemäß hohe Elastizität des Gesamtsystems trotzdem erreicht werden.
Zusätzlich umfasst die Leiterplattenhaltevorrichtung ein Rahmenbauteil, wie ein Gehäusebauteil, an das sich das erste und zweite Klemmelement, insbesondere einstückig, anschließen. Die Klemmelemente können dabei direkt an das Gehäuse des elektrischen Gerätes angespritzt werden. Möglich sind hier Verfahren wie Spritzguss oder Nano-Molding. Dadurch ist es möglich, die Leiterplatte zum Einklemmen einfach beispielsweise auf das erste Klemmelement aufzulegen und die erfindungsgemäße Klemmwirkung durch Schließen des Rahmenbauteils zu erreichen. Des Weiteren sind das erste und zweite Klemmelemente an der Leiterplatte einander gegenüberliegend angeordnet, so dass sich eine homogene Krafteinleitung in die Leiterplatte ergibt und ein Verbiegen der Leiterplatte so vermieden werden kann.

Die Unteransprüche zeigen bevorzugte Weiterbildungen der Erfindung.

In einer anderen Weiterbildung der Erfindung ist der elastische Abschnitt vorzugsweise an der Berührungsstelle des Klemmelementes zur Leiterplatte ausgebildet. Die mechanischen Belastungen, die durch die Klemmung zwischen dem Klemmelement und der Leiterplatte entstehen, werden so reduziert, da durch die erfindungsgemäße Elastizität der Klemmelemente an den Berührungsstellen mit der Leiterplatte die Berührungsflächen größer werden und sich somit die Kräfte besser verteilen.

Erfindungsgemäß besonders günstig ist eine Ausführung, in der das erste, und insbesondere das zweite, Klemmelement einen senkrecht zur Leiterplattenoberfläche angeordneten zapfenförmigen Bereich umfasst und der elastische Abschnitt im zapfenförmigen Bereich ausgebildet ist. Dadurch ist es möglich, mit dem Klemmelement ganz bestimmte Punkte auf der Leiterplatte zu fixieren und so die Stabilität der Leiterplatte beispielsweise an Stellen mit besonders schweren Bauelementen wie einem Kondensator ganz gezielt zu erhöhen.

Vorzugsweise ist der zapfenförmige Abschnitt im eingeklemmten Zustand der Leiterplatte gebogen. Auf diese Weise kann das Klemmelement auch größere Kräfte zur Oberfläche der Leiterplatte parallel aufnehmen und wirkt wie ein Feststoffgelenk. Der erfindungsgemäße Toleranzausgleich erfolgt nicht nur hinsichtlich der Leiterplattendicke sondern auch hinsichtlich einer Ausdehnung der Leiterplatte in die Breite. Auch Lageänderungen der Leiterplatte können so besser ausgeglichen werden, da sich das Klemmelement mit der Leiterplatte mitbewegen und sie aufgrund seiner Elastiztät wieder in ihre Ausgangslage zurückführen kann.

In einer weiteren bevorzugten Ausbildung umfasst das Klemmelement einen Basisbereich, an den sich der zapfenförmige Abschnitt anschließt. Der Basisbereich verleiht dem Klemmelement eine hohe Grundstabilität und stellt eine ausreichende Befestigungsfläche bereit, um das Klemmelement z.B. sicher an einem Gehäuse für die Leiterplattenhaltevorrichtung zu positionieren.

Um das Klemmelement auch zur elektrischen Kontaktierung nutzen zu können, kann es vorzugsweise aus einem elektrisch leitenden Material hergestellt werden. Somit ist einsatzabhängig eine elektrische Kontaktierung oder Isolierung der Leiterplatte beispielsweise von einem Gehäuse möglich, um beispielsweise einen ausreichenden EMV-Schutz zu gewährleisten.

In einer zusätzlichen oder alternativen Weiterbildung der Erfindung kann das Klemmelement einen Hohlraum zur Füllung mit einem Füllstoff aufweisen. Dadurch können die Eigenschaften des Klemmelements an den Anwendungsfall durch die Auswahl eines geeigneten Füllstoffes angepasst werden. Der Füllstoff kann so beispielsweise die Stabilität, das Gewicht oder die Herstellungskosten des Klemmelementes beeinflussen.

Vorzugsweise kann das Klemmelement mit dem Füllstoff und seinem Grundmaterial zusammen sowohl elektrisch leitend als auch elektrisch isolierend ausgebildet werden, um die bereits genannte elektrische Leitfähigkeit des Klemmelementes über den Füllstoff einzustellen.

Die Erfindung gibt auch eine Leiterplattenanordnung mit einer erfindungsgemäßen Leiterplattenhaltevorrichtung und einer zwischen den Klemmelementen eingeklemmten Leiterplatte an. Erfindungsgemäß ist diese Leiterplattenanordnung besonders unempfindlich gegen Toleranzabweichungen, so dass nicht nur die Leiterplattenhaltevorrichtung sondern auch die Leiterplatte beständiger und langlebiger ist.

Die Leiterplatte kann in einer besonderen Ausführung einen Zentrierabschnitt zum Einfangen eines Zentrierelementes beim Einklemmen der Leiterplatte umfassen. Auf diese Weise kann die Leiterplatte in einer vorbestimmten Position eingeklemmt werden, die auch dann gehalten werden kann, wenn die Gesamtanordnung größeren mechanischen Belastungen wie einem Schütteln ausgesetzt ist.

Das Zentrierelement kann vorzugsweise auf der selben Seite der Leiterplatte wie das erste Klemmelement angeordnet und länger als das erste Klemmelement ausgebildet sein. Auf diese Weise erfolgt die Zentrierung vor dem eigentlichen Einklemmen, so dass sich die Leiterplatte zur Zentrierung noch ausreichend bewegen kann, um sich richtig zu positionieren.

In einer weiteren bevorzugten Ausbildung der Erfindung ist das Zentrierelement als Klemmelement ausgebildet, so dass die Zentrierung ohne weiteren produktionstechnischen Aufwand in die Leiterplattenanordnung integriert werden kann.

In einer weiteren Ausführung der Leiterplattenanordnung können wenigstens 66% der Klemmelemente in einem Bereich um den Rand der Leiterplatte angeordnet sein, dessen Oberfläche weniger als 10% der Gesamtoberfläche der Leiterplatte umfasst. So kann der Rand der Leiterplatte sicher fixiert werden, so dass nicht nur die Neigung der Leiterplatte zu Schwingungen und anderen mechanischen Belastungen deutlich reduziert ist, sondern die Leiterplatte auch genügend Toleranzspielraum hat, um sich aufgrund von Wärmeausdehnung zu bewegen.

Die restlichen Klemmelemente können dabei vorzugsweise in einem Bereich mit elektronischen Bauelementen der Leiterplatte angeordnet sein, so dass diese Bauelemente gestützt werden können und die Neigung der Leiterplatte aufgrund einer uneinheitlichen Gewichtsverteilung zu Schwingungen weiter reduziert ist.

In einer Weiterbildung der Leiterplattenanordnung kann das Material wenigstens des ersten und zweiten Klemmelementes weicher als das Material der Leiterplatte sein.

Als Material für die Klemmelemente können Elastomere und Kunststoffe, wie Polypropylen oder ein Liquid-Silicone-Rubber-Material, zum Einsatz kommen. Diese besitzen eine hohe Elastizität und sind insbesondere weicher als die verwendeten Leiterplatten. So wird die Leiterplatte noch besser vor mechanischen Belastungen, wie beispielsweise einem Zerkratzen geschützt.

### Kurze Beschreibung der Zeichnungen

Nachfolgend werden bevorzugte Ausführungsformen der Erfindung unter Bezugnahme auf die begleitende Zeichnung im Detail beschrieben. In der Zeichnung ist:
- Figur 1: eine erste Ausführungsform der Leiterplattenanordnung;
- Figur 2: ein Ausschnitt der Leiterplattenanordnung aus Figur 1, wobei verschiedene Belastungsfälle gezeigt sind;
- Figur 3: eine zweite Ausführungsform der Leiterplattenanordnung;
- Figur 4: eine dritte Ausführungsform der Leiterplattenanordnung;
- Figur 5: eine vierte Ausführungsform der Leiterplattenanordnung; und
- Figur 6: die Leiterplattenanordnung von Figur 5 in teilweise geschnittener Draufsicht.

### Ausführungsformen der Erfindung

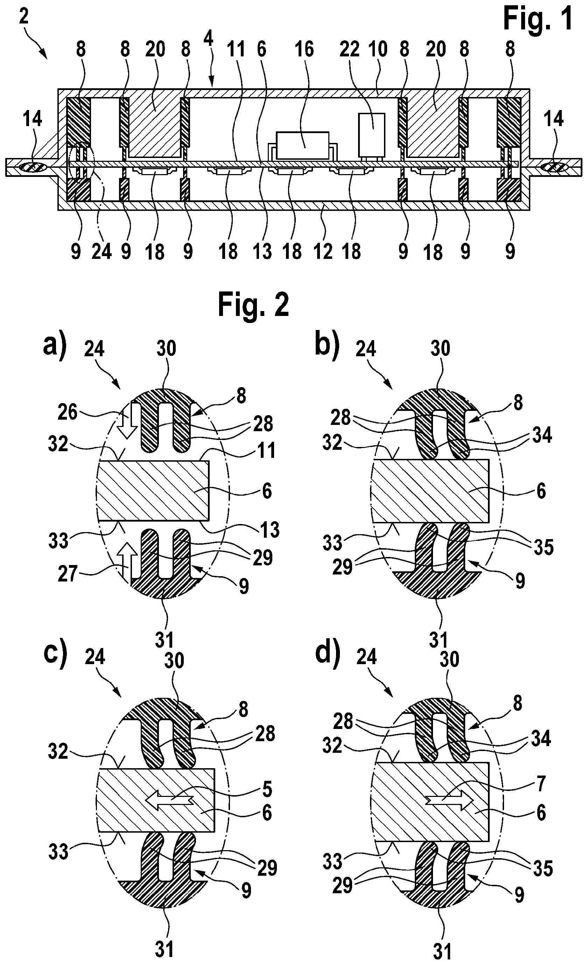

In Figur 1 ist eine erste Ausführungsform für die erfindungsgemäße Leiterplattenanordnung 2 mit einer erfindungsgemäßen Leiterplattenhaltevorrichtung in einem Schnitt von der Seite gezeigt.

Die Leiterplattenanordnung 2 ist in der vorliegenden Ausführung in einem Steuergerät eingebaut und umfasst ein Gehäusebauteil 4 sowie eine im Gehäusebauteil 4 aufgenommene Leiterplatte 6, die durch eine Vielzahl von erfindungsgemäßen Klemmelementen 8, 9 gestützt ist. Die oberen Klemmelemente 8 verbinden eine Oberseite 11 der Leiterplatte 6 mit einer Decke 10 des Gehäusebauteils 4. Die unteren Klemmelemente 9 verbinden eine Unterseite 13 der Leiterplatte 6 mit einem Boden 12 des Gehäusebauteils 4. An der Verbindungsstelle zwischen Decke 10 und Boden 12 ist eine Dichtungsmasse 14 angeordnet, um den Innenraum des Gehäusebauteils 4 vor einem Eindringen von Feuchtigkeit und Fremdpartikeln zu schützen.

An der Oberseite 11 der Leiterplatte 6 sind eine Spule 16 und ein Kondensator 22 angeordnet, während an der Unterseite 13 der Leiterplatte 6 mehrere integrierte Schaltkreise 18 angeordnet sind. Da die Spule 16 und der Kondensator 22 als Energiespeicher mehr Raum benötigen, als die integrierten Schaltkreise 18, ist der Abstand zwischen der Oberseite 11 der Leiterplatte 6 und der Decke 10 des Gehäusebauteils 4 größer als der Abstand zwischen der Unterseite 13 der Leiterplatte 6 und dem Boden 12 des Gehäusebauteil 4. An die Leiterplatte 6 sind zusätzlich Kühlbänke 20 herangeführt, die eine durch die Bauelemente 16, 18, 22 erzeugte Wärme über das Gehäusebauteil 4 an die Umgebung abgeben.

Die oberen und unteren Klemmelemente 8, 9 sind erfindungsgemäß flexibel ausgebildet und klemmen die Leiterplatte 6 zur Fixierung ihrer Position innerhalb des Gehäusebauteils 4 ein. In der vorliegenden Ausführung sind die oberen Klemmelemente 8 direkt durch Anspritzen an die Decke 10 und die unteren Klemmelemente 9 direkt durch Anspritzen an den Boden 12 des Gehäusebauteils 4 angebracht. Andere Befestigungsmethoden wie Kleben kommen jedoch ebenfalls in Frage. Alternativ können die Klemmelemente 8, 9 mit dem Gehäusebauteil 4 einstückig ausgebildet sein. Die Klemmelemente 8, 9 können beispielsweise aus Polypropylen oder einem Liquid-Silicone-Rubber hergestellt sein.

In Figur 1 ist ein Ausschnitt 24 umrandet, der vergrößert in Figur 2 in vier verschiedenen Zuständen a) bis d) für die Leiterplattenanordnung 2 dargestellt ist und zur näheren Erläuterung der Erfindung dienen soll.

Im ersten Zustand der Leiterplattenanordnung 2 gemäß Figur 2a) werden die oberen und unteren Klemmelemente 8, 9 an die Leiterplatte 6 zum Einklemmen in Richtung der Pfeile 26, 27 herangeführt. Jedes Klemmelement 8, 9 weist jeweils zwei stabförmige Zapfen 28, 29 auf, die jeweils von einem Basiskörper 30, 31 vorstehen. Solange die Leiterplatte 6 noch nicht eingeklemmt ist, erstrecken sich die stabförmigen Zapfen 28 der oben Klemmelemente 8 senkrecht zur Oberfläche 32 der Oberseite 11 der Leiterplatte 6 und die unteren Klemmelemente 9 senkrecht zur Oberfläche 33 der Unterseite 13 der Leiterplatte 6.

Im zweiten Zustand der Leiterplattenanordnung 2 gemäß Figur 2b), sind die oberen und unteren Klemmelemente 8, 9 an die Leiterplatte 6 herangeführt und klemmen sie ein. Durch das Ausüben eines Klemmdruckes auf das obere und untere Klemmelement 8, 9 biegen sich äußeren Enden 34, 35 ihrer stabförmigen Zapfen 28, 29 jeweils zu den Oberflächen 32, 33 der Leiterplatte 6 hin. Auf diese Weise ist die Leitplatte 6 zwischen den Klemmelementen 8, 9 elastisch fixiert. Wird die Leiterplatte 6 in horizontaler oder vertikaler Richtung leicht aus ihrer fixierten Klemmlage bewegt, so führen die Klemmelemente 8, 9 aufgrund ihrer Elastizität die Leiterplatte 6 wieder in diese fixierte Klemmlage zurück.

Im dritten und vierten Zustand gemäß den Figuren 2c) und 2d) ist gezeigt, wie die Klemmelemente 8, 9 die Leiterplatte 6 vor Beschädigungen aufgrund von Wärmeausdehnung schützen. Zieht sich die Leiterplatte 6 durch Abkühlung zusammen (Pfeil 5), so richten sich die stabförmigen Zapfen 28, 29 auf und halten die Leiterplatte 6 weiter sicher in der fixierten Klemmlage (Figur 2c). Demgegenüber biegen sich die äußeren Enden 34, 35 der stabförmigen Zapfen 28, 29 noch stärker zu den Oberflächen 32, 33 der Leiterplatte 6 hin und weichen ihr aus, wenn sich Leiterplatte 6 durch Erwärmung ausdehnt (Pfeil 7), so dass die Leiterplatte 6 durch die Ausdehnung nicht durch die Klemmelemente 8 beschädigt wird (Figur 2d).

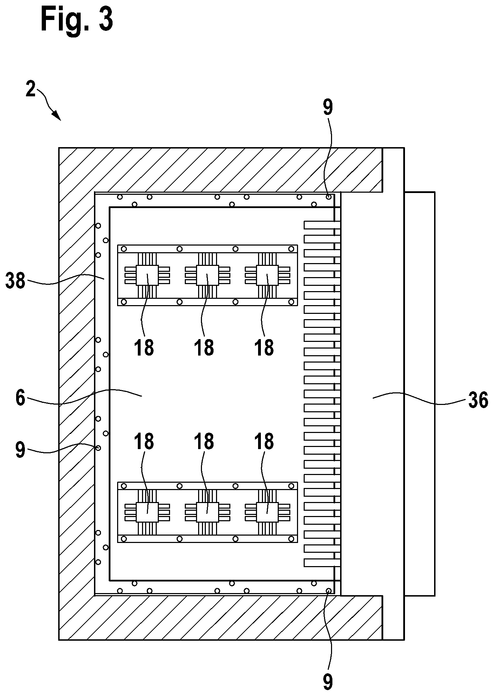

In Figur 3 ist eine zweite Ausführungsform für die erfindungsgemäße Leiterplattenanordnung 2 mit einer erfindungsgemäßen Leiterplattenhaltevorrichtung in einem Schnitt von unten gezeigt. Zur Kürze halber werden gleiche Elemente aus Figur 1 mit gleichen Bezugszeichen versehen und nicht noch einmal erklärt.

Im Gegensatz zur Leiterplattenanordnung 2 aus Figur 1 sind in der vorliegenden Ausführung auf der Leiterplatte 6 weniger integrierte Schaltkreise 18 angeordnet. Die Leiterplatte 6 besitzt eine Schnittstelle 36, um den elektrischen Schaltkreis der Leiterplatte 6 an einen elektrischen Schaltkreis eines anderen elektrischen Gerätes, wie beispielsweise einer Stromversorgung anzuschließen.

Im Randbereich 38 der Leiterplatte 6 sind dreißig der erfindungsgemäßen Klemmelemente 9 an der Unterseite 11 angeordnet. Der Randbereich 38 weist eine Fläche von circa 10% der Gesamtfläche der Leiterplatte 6 auf. Um die integrierten Schaltkreise 18 herum sind weitere sechzehn Klemmelemente 9 angeordnet. In gleicher Weise sind die oberen Klemmelemente 8 an der Oberseite 11 der Leiterplatte 6 angeordnet. In der vorliegenden Ausführungsform sind daher circa 66% der Klemmelemente 8, 9 im Randbereich 38 angeordnet, während die verbleibenden 33% innerhalb des Randbereichs um die integrierten Schaltkreise angeordnet sind. So ist die Lage der Leiterplatte 6 nicht nur optimal fixiert, sondern die einzelnen integrierten Bauelemente 18 werden auch gestützt, so dass Schwingungen der Leiterplatte 6 weitestgehend vermieden werden.

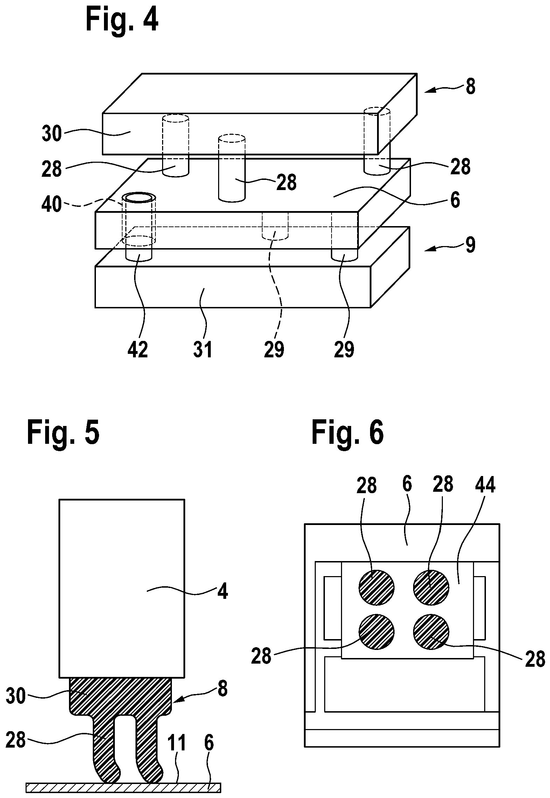

In Figur 4 ist eine dritte Ausführungsform für die erfindungsgemäße Leiterplattenanordnung 2 als Detailansicht von der Seite gezeigt.

Die oberen Klemmelemente 8 weisen hier einen gemeinsamen Basiskörper 30 und die unteren Klemmelemente 9 einen gemeinsamen Basiskörper 31 auf, von denen jeweils eine Vielzahl der zapfenförmigen Stäbe 28, 29 vorstehen. In der vorliegenden Ausführungsform drücken die elastischen zapfenförmigen Stäbe 28, 29 im eingeklemmten Zustand der Leiterplatte 6 senkrecht auf diese und verbiegen sich nicht. Dies bewirkt eine Querschnittsverbreiterung der zapfenförmigen Stäbe 28, 29 an der Berührungsstelle zur Leiterplatte 6 und stabilisiert die Lage der Leiterplatte 6 durch eine verbesserte Klemmwirkung weiter.

In der dritten Ausführungsform weist die Leiterplatte 6 weiter eine Durchgangsbohrung 40 auf, durch die ein zapfenförmiger Stab 42 des unteren Klemmelementes 9 als Zentrierelement geführt ist. Die Ausführung des Zentrierelementes als zapfenförmiger Stab 42 ist besonders günstig, da es in den Herstellungsprozess des unteren Klemmelements 9 integriert werden kann. Jedoch lässt sich das Zentrierelement auch als extra Dorn ausbilden und mit dem Basiskörper 31 des unteren Klemmelementes 9 verbinden, so dass er ebenfalls, durch die Durchgangsbohrung 40 geführt, die Leiterplatte zentrieren kann. Für den zapfenförmigen Stab 42 als Zentrierelement ist es besonders günstig, die Durchgangsbohrung 40 als Sacklochbohrung auszubilden, so dass ihr Boden als Auflage für den zapfenförmigen Stab 42 genutzt werden kann. Der zapfenförmige Stab 42 kann so nicht nur zur Zentrierung, sondern auch zur Klemmung der Leiterplatte 6 verwendet werden. Durch die Zentriermittel wird die Lage der Leiterplatte 6 beim Einklemmen zentriert und kann definiert im Gehäusebauteil 4 positioniert werden. Vorzugsweise ist der durch die Durchgangsbohrung 40 geführte zapfenförmige Stab 42 länger als die zapfenförmigen Stäbe 28, 29, die zum Einklemmen der Leiterplatte 6 dienen, so dass beim Einklemmvorgang der Leiterplatte 6 zunächst der zapfenförmige Stab 42 in die Durchgangsbohrung 40 eintritt und eine genaue Zentrierung gewährleistet.

In den Figuren 5 und 6 ist eine vierte Ausführungsform für die erfindungsgemäße Leiterplattenanordnung 2 von der Seite gezeigt, wobei hier lediglich das obere Klemmelement 8 in der Oberseite 11 des Gehäusebauteils 4 dargestellt ist.

Die Leiterplatte 6 weist an der Berührungsstelle zum Klemmelement 8 eine Kontaktstelle 44 auf, die durch das erfindungsgemäße Klemmelement 8 elektrisch kontaktierbar ist. Die Leitfähigkeit des Klemmelementes 8 kann durch eine Herstellung des Klemmelementes 8 aus einem leitfähigen Material sichergestellt werden. Auf diese Weise ist die Kontaktstelle 44 der Leiterplatte 6 mit dem Gehäuse elektrisch kontaktierbar und kann beispielsweise geerdet werden.

Zusammenfassend offenbart die Erfindung somit ein elastisches Klemmelement 8, 9 zur Fixierung einer Leiterplatte 6 in einem Gehäusebauteil 4 zwischen den Klemmelementen 8, 9. Durch die elastische Ausbildung der Klemmelemente 8, 9 werden mechanische Belastungen durch die Klemmelemente 8, 9 teilweise aufgenommen oder sogar vollständig absorbiert, so dass die Leiterplatte 6 und ihre Klemmvorrichtung langlebiger und beständiger ist.

## Patentansprüche

1. Leiterplattenhaltevorrichtung mit einem ersten Klemmelement (8) und zweiten Klemmelement (9) zum Einklemmen einer Leiterplatte (6) zwischen ihrer Oberseite (11) und Unterseite (13), wobei das erste Klemmelement (8) einen elastischen Abschnitt (28) umfasst, der zur elastischen Aufnahme von mechanischen Kräften, insbesondere senkrecht zur Oberfläche (32) der Oberseite (11) der Leiterplatte (6), vorgesehen ist, wobei das zweite Klemmelement (9) einen elastischen Abschnitt (29) umfasst, der zur elastischen Aufnahme von mechanischen Kräften, insbesondere senkrecht zur Oberfläche (33) der Unterseite (13) der Leiterplatte (6), vorgesehen ist, **dadurch gekennzeichnet, dass** die Leiterplattenvorrichtung ein Rahmenbauteil (4) umfasst, in welches die Leiterplatte aufnehmbar ist, insbesondere ein Gehäusebauteil, an das sich das erste Klemmelement (8) und das zweite Klemmelement (9), insbesondere einstückig, anschließen und das erste und zweite Klemmelement einander gegenüber angeordnet sind zur homogenen Krafteinleitung in die Leiterplatte im geklemmten Zustand ohne eine Verbiegung der Leiterplatte.

2. Vorrichtung nach Anspruch 1, wobei der elastische Abschnitt (28, 29) an der Berührungsstelle zur Leiterplatte (6) ausgebildet ist.

3. Vorrichtung nach einem der Ansprüche 1 oder 2, wobei das erste Klemmelement (8) und/oder das zweite Klemmelement (9) einen senkrecht zur Leiterplattenoberfläche (32, 33) angeordneten zapfenförmigen Bereich (28, 29) umfasst und der elastische Abschnitt (28, 29) im zapfenförmigen Bereich (28, 29) ausgebildet ist.

4. Vorrichtung nach Anspruch 3, wobei der zapfenförmige Abschnitt (28, 29) im eingeklemmten Zustand der Leiterplatte (6) gebogen ist.

5. Vorrichtung nach Anspruch 3 oder 4, wobei das erste Klemmelement (8) und/oder das zweite Klemmelement (9) einen Basisbereich (30, 31) umfasst, an den sich der zapfenförmige Abschnitt (28, 29) anschließt.

6. Vorrichtung nach einem der vorstehenden Ansprüche, wobei das erste Klemmelement (8) und/oder das zweite Klemmelement (9) aus einem elektrisch leitfähigen Material hergestellt ist.

7. Vorrichtung nach einem der vorstehenden Ansprüche, wobei eine Vielzahl von Klemmelementen (8, 9) zum Einklemmen der Leiterplatte (6) zwischen ihrer Oberseite (11) und Unterseite (13) vorgesehen sind.

8. Leiterplattenanordnung umfassend eine Leiterplattenhaltevorrichtung nach einem der vorstehenden Anordnung und eine zwischen den Klemmelementen (8, 9) eingeklemmte Leiterplatte (6).

9. Aordnung nach Anspruch 8, wobei die Leiterplatte (6) einen Zentrierabschnitt (40) zum Einfangen eines Zentrierelementes (42) beim Einklemmen der Leiterplatte (6) umfasst.

10. Anordnung nach Anspruch 9, wobei das Zentrierelement (42) auf derselben Seite der Leiterplatte (6) wie das erste Klemmelement (8) angeordnet ist und länger als das erste Klemmelement (8) ausgebildet ist.

11. Anordnung nach Anspruch 9 oder 10, wobei das Zentrierelement (42) ein Klemmelement (8) ist.

12. Anordnung nach einem der Ansprüche 8 bis 11, wobei wenigstens 66% der Klemmelemente (8, 9) in einem Bereich (38) um den Rand der Leiterplatte (6) angeordnet sind, wobei die Oberfläche des Bereichs (38) weniger als 10% der Gesamtoberfläche der Leiterplatte (6) umfasst.

13. Aordnung nach Anspruch 12, wobei die restlichen Klemmelemente (8, 9) in einem Bereich mit elektronischen Bauelementen (18) der Leiterplatte (6) angeordnet sind.

## Claims

1. Printed circuit board holding apparatus comprising a first clamping element (8) and a second clamping element (9) for clamping-in a printed circuit board (6) between its top side (11) and bottom side (13), wherein the first clamping element (8) comprises an elastic section (28) which is provided for elastically absorbing mechanical forces, in particular perpendicularly to the surface (32) of the top side (11) of the printed circuit board (6), wherein the second clamping element (9) comprises an elastic section (29) which is provided for elastically absorbing mechanical forces, in particular perpendicularly to the surface (33) of the bottom side (13) of the printed circuit board (6), **characterized in that** the printed circuit board apparatus comprises a frame component (4) in which the printed circuit board can be received, in particular a housing component which the first clamping element (8) and the second clamping element (9) adjoin, in particular in one piece, and the first and the second clamping element are arranged opposite one another for the purpose of homogeneous introduction of force into the printed circuit board in the clamped state without warping of the printed circuit board.

2. Apparatus according to Claim 1, wherein the elastic section (28, 29) is formed at the contact point to the printed circuit board (6).

3. Apparatus according to either of Claims 1 and 2, wherein the first clamping element (8) and/or the second clamping element (9) comprise/comprises a journal-like region (28, 29) which is arranged perpendicularly to the printed circuit board surface (32, 33) and the elastic section (28, 29) is formed in the journal-like region (28, 29).

4. Apparatus according to Claim 3, wherein the journal-like section (28, 29) is bent in the clamped-in state of the printed circuit board (6).

5. Apparatus according to Claim 3 or 4, wherein the first clamping element (8) and/or the second clamping element (9) comprise/comprises a base region (30, 31) which the journal-like section (28, 29) adjoins.

6. Apparatus according to one of the preceding claims, wherein the first clamping element (8) and/or the second clamping element (9) are/is produced from an electrically conductive material.

7. Apparatus according to one of the preceding claims, wherein a large number of clamping elements (8, 9) are provided for clamping-in the printed circuit board (6) between its top side (11) and bottom side (13).

8. Printed circuit board arrangement comprising a printed circuit board holding apparatus according to one of the preceding arrangement and a printed circuit board (6) which is clamped-in between the clamping elements (8, 9) .

9. Arrangement according to Claim 8, wherein the printed circuit board (6) comprises a centring section (40) for capturing a centring element (42) when clamping-in the printed circuit board (6).

10. Arrangement according to Claim 9, wherein the centring element (42) is arranged on the same side of the printed circuit board (6) as the first clamping element (8) and is formed to be longer than the first clamping element (8).

11. Arrangement according to Claim 9 or 10, wherein the centring element (42) is a clamping element (8).

12. Arrangement according to one of Claims 8 to 11, wherein at least 66% of the clamping elements (8, 9) are arranged in a region (38) around the edge of the printed circuit board (6), wherein the surface of the region (38) comprises less than 10% of the total surface of the printed circuit board (6).

13. Arrangement according to Claim 12, wherein the remaining clamping elements (8, 9) are arranged in a region with electronic components (18) of the printed circuit board (6).

## Revendications

1. Arrangement de maintien de carte à circuit imprimé comprenant un premier élément de serrage (8) et un deuxième élément de serrage (9) destinés à serrer une carte à circuit imprimé (6) entre son côté supérieur (11) et son côté inférieur (13), le premier élément de serrage (8) comportant une portion élastique (28) qui est conçue pour absorber de manière élastique des forces mécaniques, notamment perpendiculaires à la surface (32) du côté supérieur (11) de la carte à circuit imprimé (6), le deuxième élément de serrage (9) comprenant une portion élastique (29) qui est conçue pour absorber de manière élastique des forces mécaniques, notamment perpendiculaires à la surface (33) du côté inférieur (13) de la carte à circuit imprimé (6), **caractérisé en ce que** l'arrangement pour carte à circuit imprimé comporte un élément structural formant cadre (4) dans lequel peut être accueillie la carte à circuit imprimé, notamment un élément structural formant boîtier auquel se raccordent le premier élément de serrage (8) et le deuxième élément de serrage (9), notamment d'un seul tenant, et le premier et le deuxième élément de serrage étant disposés l'un par rapport à l'autre pour une transmission de force homogène dans la carte à circuit imprimé à l'état serré sans une flexion de la carte à circuit imprimé.

2. Arrangement selon la revendication 1, la portion élastique (28, 29) étant formée au niveau du point de contact avec la carte à circuit imprimé (6).

3. Arrangement selon l'une des revendications 1 et 2, le premier élément de serrage (8) et/ou le deuxième élément de serrage (9) comprenant une zone en forme de tenon (28, 29) disposée perpendiculairement à la surface de la carte à circuit imprimé (32, 33) et la portion élastique (28, 29) étant formée dans la zone en forme de tenon (28, 29).

4. Arrangement selon la revendication 3, la portion en forme de tenon (28, 29) étant courbée dans l'état serré de la carte à circuit imprimé (6).

5. Arrangement selon la revendication 3 ou 4, le premier élément de serrage (8) et/ou le deuxième élément de serrage (9) comprenant une zone de base (30, 31) à laquelle se rattache la portion en forme de tenon (28, 29) .

6. Arrangement selon l'une des revendications précédentes, le premier élément de serrage (8) et/ou le deuxième élément de serrage (9) étant fabriqués en un matériau électriquement conducteur.

7. Arrangement selon l'une des revendications précédentes, une pluralité d'éléments de serrage (8, 9) destinés à serrer la carte à circuit imprimé (6) entre son côté supérieur (11) et son côté inférieur (13) étant présents.

8. Dispositif de carte à circuit imprimé comprenant un arrangement de maintien de carte à circuit imprimé selon l'un des arrangement précédent et une carte à circuit imprimé (6) serrée entre les éléments de serrage (8, 9).

9. Dispositif selon la revendication 8, la carte à circuit imprimé (6) comportant une portion de centrage (40) destinée à capturer un élément de centrage (42) lors du serrage de la carte à circuit imprimé (6).

10. Dispositif selon la revendication 9, l'élément de centrage (42) étant disposé du même côté de la carte à circuit imprimé (6) que le premier élément de serrage (8) et étant réalisé plus long que le premier élément de serrage (8).

11. Dispositif selon la revendication 9 ou 10, l'élément de centrage (42) étant un élément de serrage (8).

12. Dispositif selon l'une des revendications 8 à 11, au moins 66 % des éléments de serrage (8, 9) étant disposés dans une zone (38) autour du bord de la carte à circuit imprimé (6), la surface de la zone (38) englobant moins de 10 % de la surface totale de la carte à circuit imprimé (6).

13. Dispositif selon la revendication 12, les éléments de serrage (8, 9) restants étant disposés dans une zone de la carte à circuit imprimé (6) pourvue de composants électroniques (18).
